# FASCICULE DE BREVET EUROPEEN

(11) **EP 2 991 895 B1**
(45) Date de publication et mention de la délivrance du brevet: **18.04.2018**
(21) Numéro de dépôt: 14727608.3
(22) Date de dépôt: 02.05.2014
(51) Int. Cl.: B64C 1/26, B64C 7/00, B64C 7/02, B64D 41/00

(54) **ENSEMBLE DE DISTRIBUTION DE PUISSANCE ÉLECTRIQUE POUR UN AVION**
STROMVERTEILERBAUGRUPPE FÜR EIN FLUGZEUG
ELECTRICAL POWER DISTRIBUTION ASSEMBLY FOR AN AIRCRAFT

(30) Priorité: 02.05.2013 FR 1354041
(43) Date de publication de la demande: 09.03.2016
(73) Titulaire: Safran Electrical & Power, 31702 Blagnac Cedex (FR)
(72) Inventeur: ROQUES, Serge, Thierry, F-31700 Cornebarrieu (FR); AVIGNON, Philippe, Pierre, F-31100 Toulouse (FR); BLINEAU, Jean-Marc, F-31840 Aussonne (FR)
(74) Mandataire: Desormiere, Pierre-Louis
(86) Numéro de dépôt international: PCT/FR2014/051046
(87) Numéro de publication internationale: WO 2014/177817

(56) Documents cités:
- EP-A2- 2 432 093
- WO-A2-02/23688
- US-A- 5 612 579

## Description

### Arrière-plan technique

L'invention qui fait l'objet de la présente divulgation s'inscrit dans le domaine des ensembles de distribution électrique pour aéronef, et des procédés de mise en place de tels ensembles.

On sait que les avions actuels, qu'il s'agisse d'avions de transport de passagers, d'avions de transport de matériel ou d'avions militaires, utilisent de plus en plus la puissance électrique pour un nombre très important de fonctions, qui étaient jusque-là effectuées grâce aux puissances hydraulique et pneumatique.

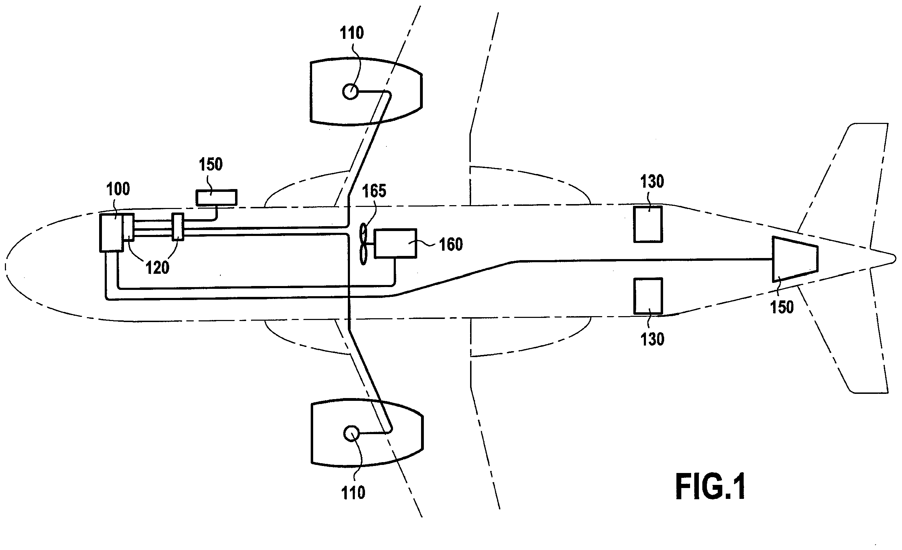

Jusqu'ici, les fonctions alimentées par la puissance électrique étaient surtout situées à l'avant de l'avion, près du cockpit, comme cela apparaît sur la **figure 1****.** On y a figuré le meuble 120VU, référencé 100, qui est un meuble d'alimentation en courant alternatif et en courant continu dans les modèles A320, utilisés à titre d'illustration. Le meuble 120VU répartit la puissance électrique qui lui est transmise depuis les générateurs 110 actionnés par les moteurs, vers les consommateurs, par exemple des cuisines 120 (*galleys* dans le langage de l'industrie) placées à l'avant de l'appareil. En dehors de l'avant des appareils, il est courant de devoir alimenter d'autres cuisines placées à l'arrière, référencées 130. Le meuble 120VU 100 est un dispositif de commutation, aussi appelé coeur électrique. Ces coeurs sont, de manière générale, situés à l'avant de l'appareil sous le cockpit, ou bien à l'arrière du cockpit sous le poste de pilotage. Ils constituent une interface entre les générateurs électriques 110 recueillant de la puissance des moteurs et la distribuant vers les diverses charges à alimenter. Un ou plusieurs groupes générateurs auxiliaires 150 sont également utilisés pour suppléer les générateurs 110 actionnés par les moteurs quand ceux-ci sont éteints, ainsi que qu'un générateur 160 relié à un générateur de secours 165 (CSMG pour *constant speed motor generator*). Ces groupes auxiliaires (APU, GPU et CSMG) alimentent le coeur électrique 100 placé à l'avant de l'appareil.

Or les modèles récents d'aéronefs incluent beaucoup plus d'équipements à alimenter en électricité. Ainsi, il est prévu que le démarrage soit électrique à l'aide d'un alternateur/démarreur, que le conditionnement d'air et la pressurisation de l'avion soit effectués à l'aide de compresseurs électriques ce qui permet de supprimer les prises d'air sur le moteur, que le dégivrage des ailes et de l'empennage soit électrique à la place d'un dégivrage à air, ou que le freinage soit électrique et non plus hydraulique. Un exemple est constitué d'un bloc de freinage électrique pour les roues d'un train principal (non représenté). De plus la tendance en matière d'organes de commande est à l'utilisation de commandes électro-hydrauliques qui demandent de fortes puissances électriques en cas de perte de puissance hydraulique pour l'actionnement des gouvernes des commandes de vol. Par exemple, on connait des actuateurs électro-mécaniques commandant des ailerons et des commandes d'électronique de puissance commandant un actionneur d'inversion de poussée. Peuvent également être actionnés par de la puissance électrique les aérofreins, les becs et les volets. On envisage également de mouvoir les trains d'atterrissage avec de la puissance électrique et de déplacer l'avion au sol également avec de la seule puissance électrique.

La puissance électrique totale nécessitée par certains appareils s'élève à 1000 kVA disponible, voire plus.

Les dispositifs consommateurs de puissance électrique (les charges) sont présents en de nombreuses zones des appareils. Les alimenter avec un coeur électrique à l'avant de l'avion implique de faire courir de longues distances de câbles. Par ailleurs, la question de la possibilité d'intervenir très rapidement sur les coeurs électriques, pendant un arrêt au sol entre deux vols de l'appareil est de plus en plus posée, à la fois parce que les utilisateurs des appareils souhaitent les utiliser sans perte de temps, et parce que de plus en plus de dispositifs embarqués sont alimentés électriquement, comme cela a été évoqué.

Le document US 5612579 divulgue un ensemble de distribution de puissance électrique pour avion comprenant un dispositif de commutation électrique primaire placé dans le fuselage de l'avion à proximité de la jonction avec la voilure.

### Définition de l'invention et avantages associés

Pour répondre aux contraintes ainsi présentées, il est proposé un avion selon la revendication 1. Grâce à cette disposition innovante, il est possible d'installer les coeurs électriques sur le chemin le plus direct pour alimenter les charges électriques, de minimiser les longueurs de câbles, notamment les câbles de puissance, qui sont lourds et difficiles à installer, et de libérer du volume interne pour donner plus de place aux espaces destinés à l'exploitation de l'avion (cabine des passagers, soute à bagages...).

Un dispositif de commutation électrique secondaire est à placer dans un triangle de soute arrière de l'avion. Les dispositions des coeurs dans le carénage de Karman et dans le triangle de soute permettent d'améliorer l'accès à la maintenance par des accès rapides aux composants sans avoir à débarquer les passagers ou le chargement.

Il est également proposé un avion comprenant un ensemble de distribution de puissance électrique tel que présenté, et dans lequel un grillage de bronze est positionné pour diminuer le champ électromagnétique dans le carénage de Karman, et/ou dans lequel un venturi provoque une fuite d'air de cabine dans le carénage de Karman pour maintenir une température tempérée dans ce carénage de Karman. Grâce à ces caractéristiques, le commutateur est protégé de certaines conditions difficiles rencontrées dans le carénage de Karman.

Il est aussi proposé un procédé de mise en place de la distribution de puissance électrique dans un avion comprenant la mise en place d'un dispositif de commutation électrique dans un carénage de Karman de l'avion. Ce procédé présente les avantages relatifs à l'ensemble de distribution électrique évoqué ci-dessus.

### Liste des figures

La figure 1 présente l'architecture de distribution électrique sur les avions actuels.
La figure 2 présente une variante d'architecture de distribution électrique connue.
La figure 3 présente une architecture de distribution électrique selon la présente divulgation.
La figure 4 présente une autre architecture de distribution électrique selon la présente divulgation.
La figure 5 présente un aspect particulier de la nouvelle architecture.

### Réalisation détaillée

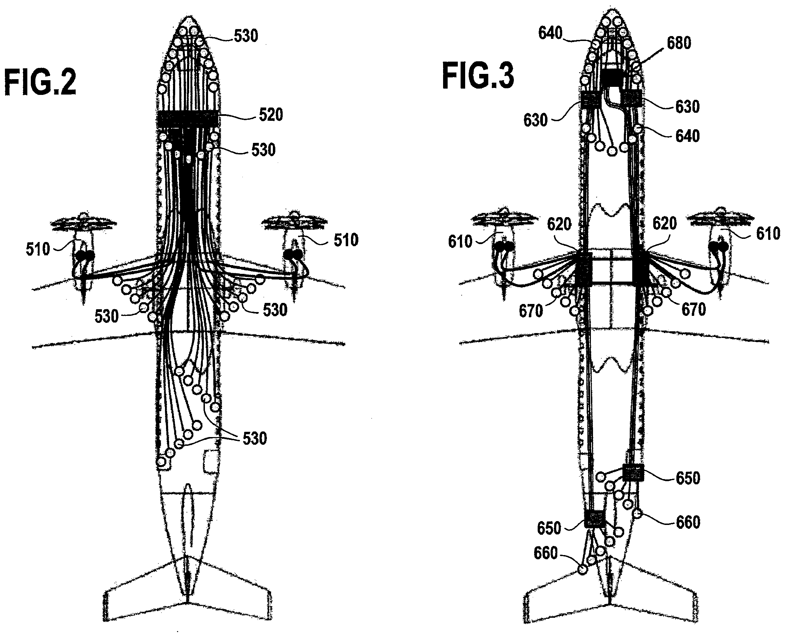

En **figure 2****,** on rappelle le réseau de distribution de puissance électrique existant dans un avion, qui peut être un avion de transport ou un avion de passager, ou encore un avion de chasse. De la puissance est extraite des réacteurs 510 placés sur les ailes et amenée sous forme électrique à des coeurs de distribution 520 placés dans l'avant de l'avion. Ici, deux coeurs sont représentés, une architecture où la distribution est redondante étant préférée pour des raisons de sécurité. Depuis ces coeurs de distribution 520, des câbles courent pour amener la puissance vers les charges 530, dans le nez de l'avion, à proximité du cockpit ou dans celui-ci, sur les ailes et dans le fuselage à l'arrière de celui-ci. Ainsi, une partie de la puissance électrique est amenée des réacteurs, vers l'avant de l'avion, puis vers l'avion, ce qui constitue un trajet long, nécessité par la centralisation de la commutation dans des coeurs situés uniquement à l'avant.

En **figure 3****,** on a représenté un nouveau réseau de distribution de la puissance électrique. Celle-ci est obtenue au niveau des réacteurs 610, puis amenée, après un trajet assez court, vers des coeurs de distribution, qualifiés de coeurs primaires, référencés 620 et placés dans le carénage de jonction entre l'aile et le fuselage, dit carénage de Karman. Les coeurs primaires sont au nombre de deux, un de chaque côté, qui reçoit la puissance fournie par le réacteur situé du même côté. A partir de ces coeurs primaires, des câbles courent vers des coeurs secondaires 630 situés à l'avant de l'avion. Ces coeurs secondaires 630 sont au nombre de deux. Ils effectuent la distribution de puissance électrique vers des charges 640 situées à l'avant de l'avion, dans le cockpit ou à proximité de celui-ci. Depuis les coeurs primaires 620, d'autres câbles amènent la puissance vers des coeurs secondaires 650 placés à l'arrière du fuselage et qui alimentent des charges 660 placées à l'arrière de l'avion. Les coeurs primaires 620 alimentent aussi directement des charges 670 placées à proximité de la voilure de l'appareil, tels les pompes à carburant, la climatisation, la pressurisation, la ventilation et la recirculation d'air de cabine, le freinage électrique, la rentrée et la sortie du train d'atterrissage par entrainement électrique ou le roulage au sol par propulsion électrique. L'avion dispose également d'un coeur de distribution de secours 680, disposé à l'avant de l'appareil.

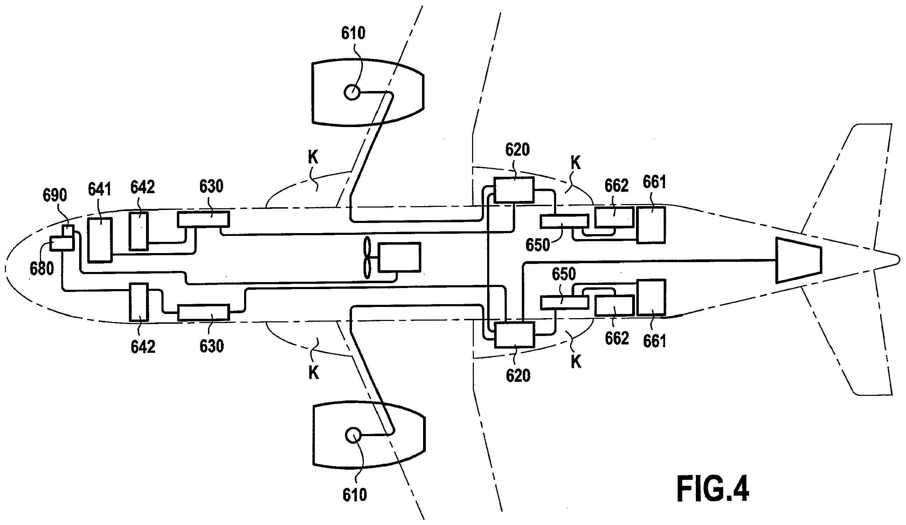

La **figure 4** montre d'autres aspects des principes ainsi évoqués. On a à nouveau figuré les générateurs 610 au niveau des réacteurs, les coeurs primaires 620, les coeurs secondaires avant 630, les coeurs secondaires arrière 650 et le coeur de distribution de secours 680. Un système de distribution de courant continu 690 est également présent.

Des charges placées à l'avant sont figurées, notamment une cuisine 641 et deux modules d'avionique 642, à gauche et à droite dans le fuselage. Ils sont chacun alimentés via le coeur secondaire avant 630 correspondant. Des charges placées à l'arrière sont également figurées, notamment deux cuisines 661 à gauche et à droite et deux modules d'avioniques 662, à gauche et à droite. Ils sont chacun alimentés via le coeur secondaire arrière 650 correspondant.

Les coeurs primaires 620 assurent la fonction de distribution primaire, et comprennent des contacteurs et des disjoncteurs à commande à distance (RCCB, pour *Remote Control Circuit Breaker*). Ils sont placés, de chaque côté, dans le carénage de Karman K de l'avion, ici dans les carénages arrière.

Les coeurs secondaires arrière 650 sont par exemple placés dans les triangles de soute arrière. Ils peuvent comprendre un disjoncteur statique (*solid-state electronics - solid state power controller* ou SSPC). Les coeurs secondaires avant 630 peuvent comprendre un disjoncteur conventionnel.

La localisation des coeurs primaires et secondaires permet les réparations de ces coeurs en dernière minute avant un décollage, alors que l'appareil est déjà chargé de passagers ou de fret, sans perturbation des opérations de chargement ou du confort des passagers.

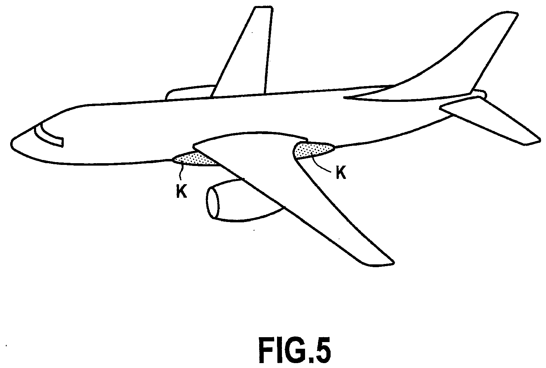

En **figure 5****,** on a représenté, vu de l'extérieur, le carénage de Karman d'un avion. Il s'agit d'une bossette aérodynamique située à la jonction de la voilure et du fuselage. Son volume intérieur est non pressurisé. Les coeurs primaires 620 sont disposés, respectivement, à l'intérieur de ces carénages de Karman, à gauche de l'appareil et à droite de l'appareil. Ils peuvent, suivant des variantes, être situés dans le carénage de Karman supérieur ou le carénage de Karman inférieur, ou le carénage de Karman avant, ou le carénage de Karman arrière. On précise qu'en figure 4, les coeurs primaires sont représentés dans les carénages de Karman K arrière.

Pour que la température dans le carénage de Karman ne diminue pas trop au cours du vol, ce qui créerait des dilatations gênantes des pièces métalliques des contacteurs, un venturi provoque une fuite d'air de cabine dans le carénage de Karman. Cet air est conditionné, ce qui permet de ne pas faire varier excessivement la température dans le carénage, par exemple de la maintenir entre -10°C et +70°C, au sol ou en vol, ce qui permet de faire fonctionner sans problème les contacteurs.

De plus, un grillage de bronze (ou en un autre matériau conducteur électrique) est positionné pour recouvrir la surface externe des panneaux du ventre du fuselage entre les ailes (le *Belly Fairing)* pour diminuer le champ électromagnétique dans le carénage de Karman, ce qui offre une protection EMI (interférences électromagnétiques) et HIRF (champs de radiation à haute intensité, comme un champ d'onde radar, ou celui d'une antenne radio puissante) compatible avec le positionnement des coeurs primaires dans cette zone de l'avion.

Les éléments constituant les contacteurs des coeurs électriques primaires sont placés dans les carénages de Karman, et donc en zone non pressurisée, dans laquelle la pression peut descendre à 0.3 bar. Les contacteurs sont renforcés, de manière à éviter la formation d'arcs électriques dans les isolants pendant le vol de l'appareil (arcs appelés décharges de Paschen). Le renforcement est défini en accord avec la puissance et les tensions électriques du réseau de bord de l'avion concerné. Egalement, les contacteurs sont étanches au ruissellement d'eau, pour éviter les court-circuits qui pourraient être causés par l'humidité pouvant se former dans les carénages de Karman, ou par les projections d'eau qui pénétreraient dans ces carénages.

L'invention n'est pas limitée aux modes de réalisation présentés, mais s'étend à toutes les variantes dans le cadre de la portée des revendications.

## Revendications

1. Avion comprenant un ensemble de distribution de puissance **caractérisé en ce que** ledit ensemble de distribution de puissance électrique comprend un dispositif de commutation électrique (620) présent dans un carénage de Karman (K) de l'avion.

2. Avion selon la revendication 1, dans lequel le dispositif de commutation électrique (620) est adapté pour effectuer une distribution primaire de la puissance électrique depuis la génération (110) de celle-ci vers les dispositifs consommateurs (641, 642, 661, 662).

3. Avion selon la revendication 1 ou la revendication 2, dans lequel un dispositif de commutation électrique secondaire (650) est à placer dans un triangle de soute arrière de l'avion.

4. Avion selon l'une des revendications 1 à 3, dans lequel un dispositif de commutation électrique secondaire (630) est à placer à l'avant de l'avion.

5. Avion selon l'une des revendications 1 à 4, dans lequel le dispositif de commutation est à placer dans un carénage de Karman supérieur.

6. Avion selon l'une des revendications 1 à 4, dans lequel le dispositif de commutation est à placer dans un carénage de Karman inférieur.

7. Avion selon l'une des revendications 1 à 4, dans lequel les contacteurs du dispositif de commutation sont étanches au ruissellement.

8. Avion selon l'une des revendications 1 à 7, dans lequel un venturi provoque une fuite d'air de cabine dans le carénage de Karman (K).

9. Avion selon l'une des revendications 1 à 7, et dans lequel un grillage de bronze ou en un autre matériau électriquement conducteur est positionné pour diminuer le champ électromagnétique dans le carénage de Karman (K).

10. Procédé de mise en place de la distribution de puissance électrique dans un avion comprenant la mise en place d'un dispositif de commutation électrique (620) dans un carénage de Karman (K) de l'avion.

## Patentansprüche

1. Flugzeug, umfassend eine Anordnung zur Leistungsverteilung, **dadurch gekennzeichnet, dass** die Anordnung zur Verteilung elektrischer Leistung eine elektrische Umschaltvorrichtung (620), welche in einer Karman-Verkleidung (K) des Flugzeuges vorhanden ist, umfasst.

2. Flugzeug nach Anspruch 1, bei dem die elektrische Umschaltvorrichtung (620) dazu ausgelegt ist, eine primäre Verteilung der elektrischen Leistung von deren Erzeugung (110) hin zu den Verbrauchervorrichtungen (641, 642, 661, 662) zu vollziehen.

3. Flugzeug nach Anspruch 1 oder Anspruch 2, bei dem eine sekundäre elektrische Umschaltvorrichtung (650) in einem hinteren Frachtraumdreieck des Flugzeuges anzuordnen ist.

4. Flugzeug nach einem der Ansprüche 1 bis 3, bei dem eine sekundäre elektrische Umschaltvorrichtung (630) im vorderen Teil des Flugzeuges anzuordnen ist.

5. Flugzeug nach einem der Ansprüche 1 bis 4, bei dem die Umschaltvorrichtung in einer oberen Karman-Verkleidung anzuordnen ist.

6. Flugzeug nach einem der Ansprüche 1 bis 4, bei dem die Umschaltvorrichtung in einer unteren Karman-Verkleidung anzuordnen ist.

7. Flugzeug nach einem der Ansprüche 1 bis 4, bei dem die Schütze der Umschaltvorrichtung rieseldicht sind.

8. Flugzeug nach einem der Ansprüche 1 bis 7, bei dem eine Venturi-Düse ein Entweichen von Kabinenluft in die Karman-Verkleidung (K) bewirkt.

9. Flugzeug nach einem der Ansprüche 1 bis 7, bei dem ein Gitter aus Bronze oder aus einem anderen elektrisch leitenden Werkstoff angeordnet ist, um das elektromagnetische Feld in der Karman-Verkleidung (K) zu verringern.

10. Verfahren zum Einbringen der Verteilung elektrischer Leistung in ein Flugzeug, umfassend das Anbringen einer elektrischen Umschaltvorrichtung (620) in einer Karman-Verkleidung (K) des Flugzeuges.

## Claims

1. An airplane including an electrical power distribution assembly **characterized in that** said electrical power distribution assembly comprises an electric switch device (620) present in a Karman fairing (K) of the airplane.

2. An airplane according to claim 1, wherein the electric switch device (620) is adapted to perform primary distribution of electrical power from its generation (110) to consumer devices (641, 642, 661, 662).

3. An airplane according to claim 1 or claim 2, wherein a secondary electric switch device (650) is placed in a rear hold triangle of the airplane.

4. An airplane according to any one of claims 1 to 3, wherein the secondary electric switch device (630) is placed at the front of the airplane.

5. An airplane according to any one of claims 1 to 4, wherein the switch device is for placing in a top Karman fairing.

6. An airplane according to any one of claims 1 to 4, wherein the switch device is for placing in a bottom Karman fairing.

7. An airplane according to any one of claims 1 to 4, wherein the contactors of the switch device are proof against water runoff.

8. An airplane according to any one of claims 1 to 7, wherein a Venturi causes air to leak from the cabin into the Karman fairing (K).

9. An airplane according to any one of claims 1 to 7, wherein a grid made of bronze or some other electrically conductive material is positioned to reduce the electromagnetic field in the Karman fairing (K).

10. A method of putting electrical power distribution into place in an airplane including placing an electric switch device (620) in a Karman fairing (K) of the airplane.
